# EUROPEAN PATENT APPLICATION

(11) **EP 4 836 650 A1**
(43) Date of publication of application: **04.11.2026**
(21) Application number: 26162209.6
(22) Date of filing: 04.03.2026
(51) Int. Cl.: H10K 59/122, H10K 50/11, H10K 59/80

(54) **DISPLAY DEVICE, METHOD OF MANUFACTURING THE SAME AND ELECTRONIC DEVICE COMPRISING THE SAME**

(30) Priority: 02.05.2025 KR 20250058131
(71) Applicant: Samsung Display Co., Ltd., Yongin-si, Gyeonggi-do 17113 (KR)
(72) Inventor: MOON, Young Min, 17113 Giheung-gu, Yongin-si, Gyeonggi-do (KR); KIM, A Rong, 17113 Giheung-gu, Yongin-si, Gyeonggi-do (KR); KIM, Jae Ik, 17113 Giheung-gu, Yongin-si, Gyeonggi-do (KR); PARK, Jin Min, 17113 Giheung-gu, Yongin-si, Gyeonggi-do (KR); YANG, Hee Jun, 17113 Giheung-gu, Yongin-si, Gyeonggi-do (KR); LEE, Sa Min, 17113 Giheung-gu, Yongin-si, Gyeonggi-do (KR)
(74) Representative: Dr. Weitzel & Partner

(57) **Abstract**

A display device includes: a base substrate; a transistor structure on the base substrate; a pixel electrode electrically connected to the transistor structure on the base substrate; a pixel defining layer partially covering the pixel electrode, and having an opening overlapped the pixel electrode; a sidewall structure at an outer lower portion of the pixel defining layer and comprising an outer groove; an emission portion on the pixel defining layer and the pixel electrode; and an opposing electrode on the emission portion and contacting the sidewall structure.

## Description

The present invention relates to a display device, a method of manufacturing the same and an electronic device comprising the same.

In display devices such as Organic Light Emitting Diode (OLED) display devices and Liquid Crystal Display (LCD) devices, for example, a display substrate comprising Thin Film Transistors (TFT) and various wirings may be provided, and a display structure comprising electrodes and an emission layer may be formed on the display substrate.

For example, pixel electrodes connecting the TFT and the display structure, and a pixel defining layer that defines pixel areas may be utilized. Recently, various designs of the aforementioned TFT, pixel electrode, and pixel defining layer have been studied to more stably implement a high-resolution display device.

The above information disclosed in this Background section is only for enhancement of understanding of the background and therefore the information discussed in this Background section does not necessarily constitute prior art.

The present invention relates to a display device, a method of manufacturing the same and an electronic device comprising the same. Specifically, the present invention relates to a display device comprising a pixel electrode and a pixel defining layer, a method of manufacturing the same, and an electronic device comprising the same.

Aspects of some embodiments of the present invention include a display device with relatively improved driving reliability and emission characteristics.

Aspects of some embodiments of the present invention include a method of manufacturing a display device with relatively improved driving reliability and emission characteristics.

Aspects of some embodiments of the present invention include an electronic device comprising a display device with relatively improved driving reliability and emission characteristics.

The invention is defined by the features of the independent claims. The dependent claims and the description provide preferred embodiments.

A display device according to the present invention comprises: a base substrate; a transistor structure on the base substrate; a pixel electrode electrically connected to the transistor structure on the base substrate; a pixel defining layer partially covering the pixel electrode, and having an opening overlapped the pixel electrode; a sidewall structure formed at an outer lower portion of the pixel defining layer and comprising an outer groove; an emission portion formed on the pixel defining layer and the pixel electrode; and an opposing electrode formed on the emission portion and contacting the sidewall structure.

According to some embodiments, the sidewall structure may comprise a first conductive layer, a second conductive pattern, and a third conductive pattern sequentially stacked on the base substrate. The outer groove may be defined by an upper surface of the first conductive layer, a side surface of the second conductive pattern, and a lower surface of the third conductive pattern.

According to some embodiments, the opposing electrode may contact a side surface of the third conductive pattern.

According to some embodiments, the emission portion may cover an outer side surface of the pixel defining layer and does not contact the second conductive pattern of the sidewall structure.

According to some embodiments, the emission portion may not contact the lower surface of the third conductive pattern.

According to some embodiments, the opposing electrode may not contact the first conductive layer.

According to some embodiments, at least one of the first conductive layer, the second conductive pattern, or the third conductive pattern may be positioned in a same layer or at a same level as the pixel electrode.

According to some embodiments, the second conductive pattern may comprise a metal different from that of each of the first conductive layer and the third conductive pattern.

According to some embodiments, the first conductive layer and the third conductive pattern may comprise titanium (Ti) and the second conductive pattern may comprise aluminum (Al).

According to some embodiments, the display device may comprise a plurality of pixels. The first conductive layer of the sidewall structure may be a common connection electrode formed across neighboring pixels of the plurality of pixels.

According to some embodiments, the plurality of pixels may comprise a first pixel, a second pixel, and a third pixel. The pixel electrode may comprise a first pixel electrode, a second pixel electrode, and a third pixel electrode corresponding to the first pixel, the second pixel, and the third pixel, respectively. The opposing electrode may comprise a first opposing electrode, a second opposing electrode, and a third opposing electrode on the first pixel electrode, the second pixel electrode, and the third pixel electrode, respectively. The first opposing electrode, the second opposing electrode, and the third opposing electrode may be electrically connected to each other through the first conductive layer of the sidewall structure.

According to some embodiments, the emission portion may extend continuously in the opening.

According to some embodiments, an inner groove may be formed between an outer portion of an upper surface of the pixel electrode and the pixel defining layer.

According to some embodiments, the emission portion may comprise a hole injection layer, a hole transport layer, an emission layer, and an electron transport layer sequentially stacked on the pixel electrode. The hole injection layer may be discontinuous by the inner groove.

According to some embodiments, the display device may further comprise a sacrificial pattern formed in the inner groove.

A method of manufacturing a display device according to the present invention comprises: forming a pixel electrode and a sidewall structure stack on a base substrate; forming a pixel defining layer covering the pixel electrode and partially covering the sidewall structure stack on the base substrate; forming a sidewall structure by partially etching the sidewall structure stack exposed from the pixel defining layer; forming an emission portion on the pixel defining layer and the pixel electrode; and forming an opposing electrode contacting the sidewall structure on the emission portion.

According to some embodiments, the sidewall structure stack may comprise a first conductive layer, a second conductive layer, and a third conductive layer sequentially formed from the base substrate. The forming of the sidewall structure may comprise: forming a third conductive pattern by removing a portion of the third conductive layer exposed from the pixel defining layer through dry etching; and forming an outer groove by selectively partially removing the second conductive layer to form a second conductive pattern through wet etching.

According to some embodiments, the emission portion and the opposing electrode may be formed to be discontinuous by the outer groove.

An electronic device according to the present invention comprises: a display device; a memory; and a processor controlling an operation of the display device by executing a data comprised in the memory, wherein the display device comprises: a base substrate; a transistor structure on the base substrate; a pixel electrode electrically connected to the transistor structure on the base substrate; a pixel defining layer partially covering the pixel electrode, and having an opening overlapped the pixel electrode; a sidewall structure formed at an outer lower portion of the pixel defining layer and comprising an outer groove; an emission portion formed on the pixel defining layer and the pixel electrode; and an opposing electrode formed on the emission portion and contacting the sidewall structure.

According to some embodiments, the electronic device may comprise virtual reality or augmented reality glasses, a smartphone, a tablet PC, a laptop, a television, a desk monitor, smart glasses, a head-mounted display, a smart watch, or an in-vehicle display.

In a display device according to some embodiments of the present invention, a sidewall structure having an outer groove may be formed on a side of a pixel defining layer. Through the outer groove of the sidewall structure, patterning of an emission area for each pixel may be implemented while maintaining a continuous emission area on the pixel electrode. In addition, through the sidewall structure, the connectivity of the cathode may be maintained across a plurality of pixels.

At least a part of the sidewall structure is at a same level as the pixel electrode, so that the pixel-by-pixel patterning of the emission area and the connectivity of the cathode may be implemented without the introduction of an additional conductive structure.
FIG. 1 is a schematic plan view illustrating a display device according to an embodiment of the present invention.
FIG. 2 is a pixel equivalent schematic of a display device according to an embodiment of the present invention.
FIG. 3 is a schematic cross-sectional view illustrating a display device according to an embodiment of the present invention.
FIGS. 4 to 6 are schematic partially enlarged cross-sectional views illustrating a stacked arrangement of an emission portion, an opposing electrode, and an encapsulation layer around a sidewall structure, according to an embodiment of the present invention.
FIGS. 7 to 11 are schematic partially enlarged cross-sectional views illustrating a method of manufacturing a display device according to an embodiment of the present invention.
FIGS. 12 and 13 are schematic plan and sectional views, respectively, illustrating display devices according to an embodiment of the present invention.
FIGS. 14 to 16 are schematic cross-sectional views illustrating methods of manufacturing a display device according to an embodiment of the present invention.
FIG. 17 is a schematic cross-sectional view illustrating a display device according an embodiment of the present invention.
FIG. 18 is a schematic partially enlarged cross-sectional view illustrating a shape of separation of the emission portion by an inner groove, according an embodiment of the present invention.
FIGS. 19 to 21 are schematic cross-sectional views illustrating a method of manufacturing a display device according to an embodiment of the present invention.
FIG. 22 is an exploded perspective view of an electronic device according to an embodiment of the present invention.
FIG 23 is a block diagram of an electronic device according to an embodiment of the present invention.
FIG. 24 is a schematic diagram of an electronic device according to an embodiment of the present invention.

Hereinafter, preferred embodiments of the present invention will be described in more detail with reference to the accompanying figures. In doing so, the same reference numerals are used for identical components in the figures, and some redundant descriptions of identical or similar components may be omitted for brevity.

As used herein, the terms "on," "connected," "coupled," "combined," and the like comprise direct disposition/connection/joining as well as interposition of other components.

The terms "first," "second," "below," "on the bottom," "on top," "above," "on the top," and the like are used as relative concepts to distinguish between different configurations or positions and are not intended to specify absolute position, order, or otherwise.

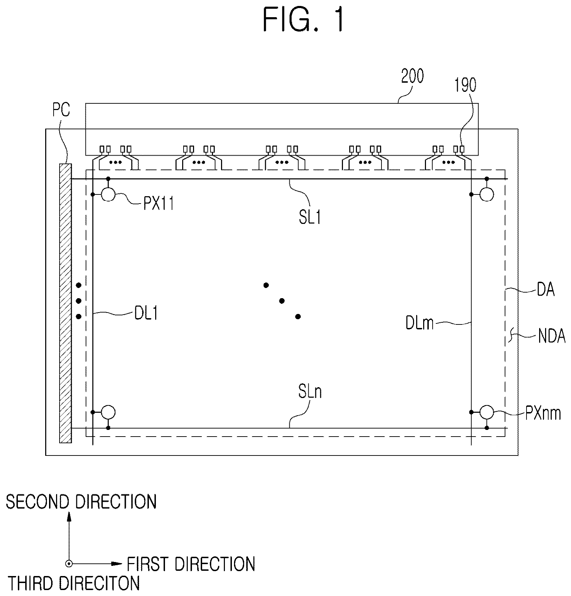

FIG 1 is a schematic plan view illustrating a display device according to some embodiments.

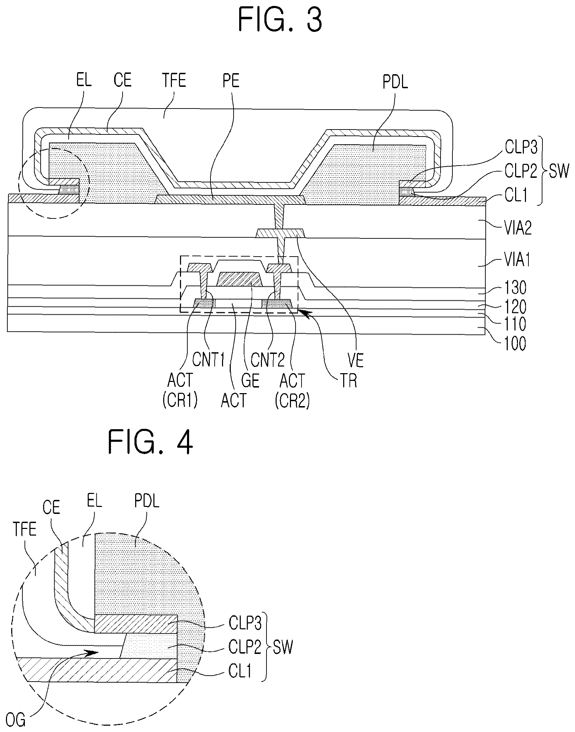

In FIG. 1, a first direction and a second direction may refer to two directions parallel to an upper surface of the base substrate 100 (see FIG. 3) and intersecting each other. For example, the first direction and the second direction may be orthogonal to each other.

For example, the first direction may correspond to an X direction (e.g., a row direction or a length direction) of the display device, and the second direction may correspond to a Y direction (a column direction or a width direction) of the display device.

The third direction may be perpendicular to a plane defined by the first direction and the second direction. The third direction may correspond to a Z direction (thickness direction) of the display device, or a direction perpendicular to a plane of a display surface of the display device.

In the following figures, the above definitions of directions may be applied equally.

Referring to FIG. 1, a display device may comprise a display area DA and a non-display area NDA. The display area DA may provide a surface on which images of the display device are displayed and on which user touch/commands are input. The non-display area NDA may correspond to a bezel area or a periphery area of the display device. According to some embodiments, the display area DA may be surrounded (or substantially surrounded) by the non-display area NDA. For example, the non-display area NDA may be in a periphery or outside a footprint of the display area DA.

The base substrate 100 may also be divided into a display area DA and a non-display area NDA. A plurality of pixels PX11 to PXnm may be arranged in the display area DA of the base substrate 100, wherein n and m are natural numbers greater than 1.

According to some embodiments, a pixel circuit comprising scan lines (or gate lines) SL1 to SLn forming the first row to n-th rows and data lines DL1 to DLm forming the first column to m-th columns of the display device may be arranged on the base substrate 100. Each of the pixels PX11 to PXnm may be connected to n rows of scan lines corresponding to the plurality of scan lines SL1 to SLn and m rows of data lines corresponding to the plurality of data lines DL1 to DLm.

Each of the pixels PX11 to PXnm may further comprise a pixel circuit comprising transistors and a light emitting element, as described later. According to some embodiments, the pixel circuit may further comprise wirings such as a power line, a ground line, and the like.

In FIG. 1, data lines DL1 to DLm are shown extending in the second direction and scan lines SL1 to SLn are shown extending in the first direction, but are not necessarily limited thereto. Also, in FIG. 1, the shape of each pixel PX11 to PXnm is shown as a circular for convenience of illustration, but is not limited thereto.

In the non-display area NDA corresponding to the periphery area with respect to the display area DA, a periphery circuit PC may be arranged. For example, the periphery circuit PC may comprise a gate drive circuit. The gate drive circuit may be integrated into the display device through an oxide semiconductor gate (OSG), amorphous silicon gate (ASG), or polysilicon gate (PSG) drive circuit process.

The periphery circuit PC may further comprise a data driver, a gate driver, an emission driver, a power supply voltage generator, a timing controller, and the like.

The display device may further comprise a printed circuit board 200. Pads 190 of the pixel circuit may be aggregated on a side of the non-display area NDA. The printed circuit board 200 may be electrically connected to the pixel circuit through the pads 190. For example, the printed circuit board 200 may be electrically connected to the pads 190 by a heat-and-press process using a conductive interposition structure, such as an anisotropic conductive film (ACF).

An integrated circuit IC, such as a data drive circuit, may be located on the printed circuit board 200. According to some embodiments, an integrated circuit IC chip may be mounted on the printed circuit board 200 in a form of a chip-on-film COF.

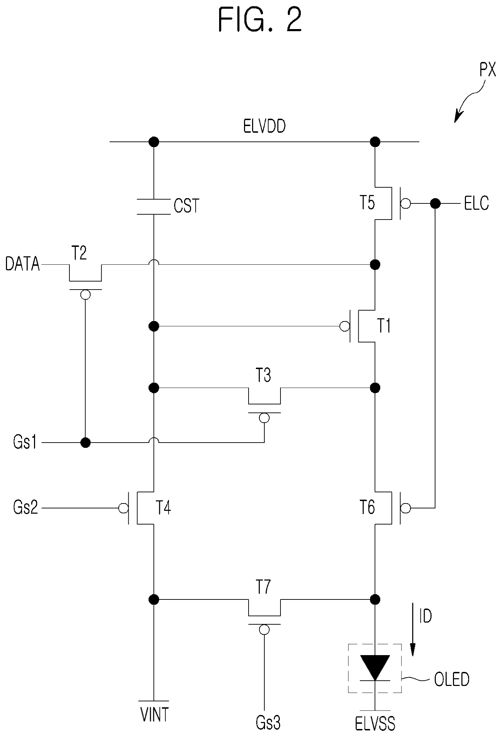

FIG. 2 is a pixel equivalent schematic of a display device according to some embodiments. Although FIG. 2 illustrates various components in a pixel according to some embodiments, embodiments according to the present invention are not limited thereto, and according to various embodiments, the pixel may include additional components, or fewer components.

Referring to FIG. 2, each pixel PX may comprise a first transistor T1, a second transistor T2, a third transistor T3, a fourth transistor T4, a fifth transistor T5, a sixth transistor T6, a seventh transistor T7, and a storage capacitor CST.

The first transistor T1 may comprise a gate terminal, a first terminal, and a second terminal. The gate terminal may be connected to the storage capacitor CST. The first terminal may be connected to a second transistor T2. The second terminal may be connected to a sixth transistor T6. The first transistor T1 may generate a driving current ID based on a voltage difference between the gate terminal and the first terminal. For example, the first transistor T1 may be referred to as a driving transistor.

The second transistor T2 may comprise a gate terminal, a first terminal, and a second terminal. The gate terminal of the second transistor T2 may receive a first gate signal Gs1. The second transistor T2 may be turned on or turned off in response to the first gate signal Gs1. The first terminal of the second transistor T2 may receive a data voltage DATA. The second transistor T2 may provide a data voltage DATA to the first terminal of the first transistor T1 in response to the first gate signal Gs1. For example, the second transistor T2 may be referred to as a switching transistor.

The third transistor T3 may comprise a gate terminal, a first terminal, and a second terminal. The gate terminal may receive a first gate signal Gs1. The first terminal may be connected to the gate terminal of the first transistor T1. The second terminal may be connected to the second terminal of the first transistor T1. The third transistor T3 may compensate the threshold voltage of the first transistor T1. For example, the third transistor T3 may be provided as a compensation transistor.

The fourth transistor T4 may comprise a gate terminal, a first terminal, and a second terminal. The gate terminal may receive a second gate signal Gs2. The first terminal may be connected to the gate terminal of the first transistor T1. The second terminal may receive an initialization voltage VINT. A fourth transistor T4 may initialize the gate terminal of the first transistor T1.

The fifth transistor T5 may comprise a gate terminal, a first terminal, and a second terminal. The gate terminal may receive an emission control signal ELC. The first terminal may receive a high supply voltage ELVDD. The second terminal may be connected to the first terminal of a first transistor T1.

The sixth transistor T6 may comprise a gate terminal, a first terminal, and a second terminal. The gate terminal may receive an emission control signal ELC. The first terminal may be connected to the second terminal of the first transistor T1. The second terminal may be connected to the organic light emitting diode OLED. The sixth transistor T6 may transmit a driving current ID to the organic light emitting diode OLED in response to the emission control signal ELC.

The seventh transistor T7 may comprise a gate terminal, a first terminal, and a second terminal. The gate terminal may receive a third gate signal Gs3. The first terminal may be connected to an organic light emitting diode OLED. The second terminal may receive an initialization voltage VINT. The seventh transistor T7 may initialize the organic light emitting diode OLED. The storage capacitor CST may comprise a first terminal and a second terminal. The first terminal may receive a high supply voltage ELVDD. The second terminal may be connected to a gate terminal of the first transistor T1.

The organic light emitting diode OLED may comprise a first terminal and a second terminal. The first terminal may be connected to the second terminal of a sixth transistor T6. The second terminal may receive a low supply voltage ELVSS. The organic light emitting diode OLED may emit light based on a driving current ID.

In FIG. 2, a structure of a 7T1C with seven thin-film transistors and one storage capacitor CST per pixel PX is illustrated, but the pixel structure of the display device disclosed herein is not necessarily limited thereto.

For example, each pixel PX may comprise two or more transistors, and may have a structure of 2T1C, 5T1C, 6T1C, 5T2C, 6T2C, etc.

FIG 3 is a cross-sectional view illustrating aspects of a display device according to some embodiments.

Referring to FIG. 3, the display device may comprise a base substrate 100, a pixel circuit comprising a transistor structure TR, and a light emitting element.

The base substrate 100 may be provided as a back-plane substrate of the display device. A glass substrate, ceramic substrate, or plastic substrate may be used as the base substrate 100. According to some embodiments, the base substrate 100 may comprise a polymer material having transparency and a flexibility (e.g., a set or predetermined flexibility). In this case, the base substrate 100 may be employed in a transparent flexible display device.

For example, the base substrate 100 may comprise a polymer material such as polyimide, polysiloxane, epoxy-based resin, acrylic-based resin, or polyester. According to some embodiments, the base substrate 100 may comprise polyimide.

According to some embodiments, the base substrate 100 may be a glass substrate. According to some embodiments, the base substrate 100 may be a silicon substrate manufactured from a silicon wafer.

A buffer layer 110 may be formed on an upper surface of the base substrate 100. By the buffer layer 110, moisture infiltrating through the base substrate 100 may be blocked, and diffusion of impurities between the base substrate 100 and the structure formed on the base substrate 100 may be blocked. The buffer layer 110 may be formed entirely across the display area DA and the non-display area NDA of the base substrate 100, and may cover the upper surface of the base substrate 100 entirely.

The buffer layer 110 may comprise an inorganic insulating material, such as, for example, silicon oxide, silicon nitride, or silicon oxynitride. These may be used alone or in combination of two or more.

According to some embodiments, the buffer layer 110 may have a stacked structure comprising a silicon oxide film and a silicon nitride film. The buffer layer 110 may be formed by a deposition process, such as a chemical vapor deposition (CVD) process, a sputtering process, an atomic layer deposition (ALD) process, or the like, to comprise the inorganic insulating materials described above.

According to some embodiments, the buffer layer 110 may comprise an organic layer, and may have a multilayer structure of organic and inorganic layers.

The pixel circuit may comprise wirings comprising scan lines and data lines as described with reference to FIG. 1, and a transistor structure TR electrically interacting with the wirings. The transistor structure TR may be electrically connected to the light emitting element.

The transistor structure TR may comprise an active layer ACT, a gate insulating layer 120, and a gate electrode GE. The transistor structure TR may further comprise contact electrodes CNT1, CNT2.

The active layer ACT is located on the buffer layer 110 and may be patterned, for example, by a photolithography etch process, to have a repetitive/regular arrangement for each pixel. The active layer ACT may comprise a silicon compound, such as polysilicon or amorphous silicon. Some regions of the active layer ACT may be doped with p-type dopants or n-type dopants, and may comprise source regions, drain regions, and channel regions.

The active layer ACT may also comprise an oxide semiconductor such as Indium Gallium Zinc Oxide (IGZO), Zinc Tin Oxide (ZTO), or ITZO.

A gate insulating layer 120 is formed on top of the active layer ACT, and a gate electrode GE may be stacked on the gate insulating layer 120. The gate insulating layer 120 may be continuously and commonly comprised for a plurality of transistor structures TR or pixels of different colors.

Alternatively, the gate insulating layer 120 may partially cover each active layer ACT and may be formed in an independent pattern in each of the transistor structures TR.

The gate electrode GE may be overlapped with the channel region of the active layer ACT in a third direction. Scan signals from the scan line may be transmitted through the gate electrodes GE.

The gate insulating layer 120 may be formed by a deposition process described above to comprise an inorganic insulating material such as silicon oxide, silicon nitride, silicon oxynitride, metal oxide, or the like.

According to some embodiments, p-type dopants or n-type dopants may be implanted into the active layer ACT by an ion implantation process using the gate electrode GE as an ion implantation mask. Accordingly, a first contact region CR1 and a second contact region CR2 may be formed on one side and the other side of the active layer ACT, respectively. The first contact region CR1 and the second contact region CR2 may correspond to a source region and a drain region, respectively.

A portion of the active layer ACT between the first contact region CR1 and the second contact region CR2, overlapping the gate electrode GE in a perpendicular direction (the third direction shown above), may be defined as a channel region.

According to some embodiments, the gate insulating layer 120 may be formed in a pattern covering the channel region by an etch process using a gate electrode GE as an etch mask. If the active layer ACT comprises an oxide semiconductor, hydrogen (H) contained in the interlayer insulating layer 130 may diffuse or migrate into the active layer ACT upon formation of the interlayer insulating layer 130. Accordingly, the carrier concentration may be increased by the hydrogen, and contact regions CR1, CR2 may be formed on the side portions of the active layer ACT.

On the active layer ACT, an interlayer insulating layer 130 covering the gate insulating layer 120 and the gate electrode GE may be formed. The interlayer insulating layer 130 may be formed by the deposition process described above to comprise an inorganic insulating material such as silicon oxide, silicon nitride, silicon oxynitride, or the like. The interlayer insulating layer 130 may be formed as a monolayer structure or as a multilayer structure comprising different materials.

Contact electrodes CNT1, CNT2 that are in contact with or electrically connected to an active layer ACT may be formed on the interlayer insulating layer 130.

The contact electrodes may comprise a first contact electrode CNT1 in contact or electrical connection with a first contact region CR1 of the active layer ACT and a second contact electrode CNT2 in contact or electrical connection with a second contact region CR2 of the active layer ACT. According to some embodiments, the first contact electrode CNT1 and the second contact electrode CNT2 may be provided as a source electrode and a drain electrode, respectively.

According to some embodiments, the interlayer insulating layer 130 may be partially etched to form contact holes. For example, contact holes may be formed to expose a first contact region CR1 and a second contact region CR2, respectively. The contact holes may also penetrate the gate insulating layer 120.

A metal layer filling the contact holes may be formed on the interlayer insulating layer 130, and then the metal layer may be partially etched to form the first contact electrode CNT1 and the second contact electrode CNT2. For example, a data signal may be transmitted from the data line through the first contact electrode CNT1.

The gate electrode GE and contact electrodes CNT1, CNT2 may comprise metals such as Ag, Mg, Al, W, Cu, Ni, Cr, Mo, Ti, Pt, Ta, Nd, Sc, or alloys thereof, or nitrides thereof. The gate electrode GE and contact electrodes CNT1, CNT2 may be formed via a deposition process, such as a sputtering process.

The gate electrode GE and contact electrodes CNT1, CNT2 may be formed in a multilayer structure (e.g., Ti layer, Al layer, and Ti layer).

The transistor structure TR illustrated in FIG. 3 may comprise a pixel driving transistor connected to the pixel electrode PE. A plurality of transistor structures TR may be formed to be comprised in each pixel PX to form a thin film transistor (TFT) array.

A first via insulating layer VIA1 covering the contact electrodes CNT1, CNT2 may be formed on the interlayer insulating layer 130. A second via insulating layer VIA2 may be formed on top of the first via insulating layer VIA1. The first and second via insulating layers VIA1 and VIA2 may be provided as planarization layers of a thin-film transistor (TFT)-array.

A via electrode VE may penetrate the first via insulating layer VIA1 and may be in contact or electrically connected to the upper surface of a contact electrode (e.g., a second contact electrode CNT2).

For example, the first via insulating layer VIA1 may be partially etched to form a first via hole that exposes the upper surface of a contact electrode (e.g., a second contact electrode CNT2). The first via hole may be filled and a via electrode layer comprising the above described metal or alloy may be formed by a deposition process such as a sputtering process.

The via electrode layer formed on the upper surface of the first via insulating layer VIA1 may be partially etched to form the via electrode VE. Then, a second via insulating layer VIA2 covering the via electrode VE may be formed on the first via insulating layer VIA1.

The via insulating layers VIA1, VIA2 may be formed by an organic insulating layer. For example, the via insulating layers VIA1, VIA2 may comprise organic polymer materials such as polyimide, epoxy-based resin, acrylic-based resin, polyester, siloxane-based resin, benzocyclobutene (BCB), and the like. For example, the via insulating layers VIA1, VIA2 may be formed by a coating process, such as a spin coating process.

According to some embodiments, the first via insulating layer VIA1 or the second via insulating layer VIA2 may be formed from an inorganic insulating material such as silicon oxide, silicon nitride, or silicon oxynitride. For example, the first via insulating layer VIA1 or the second via insulating layer VIA2 may be formed by a deposition process, such as a CVD process.

A pixel electrode PE electrically connected to a transistor structure TR through a via electrode VE and a second contact electrode CNT2 may be formed on the second via insulating layer VIA2.

For example, a second via insulating layer VIA2 may be partially etched to form a second via hole that exposes the upper surface of the via electrode VE. A pixel electrode layer filling the second via hole may be formed on the upper surface of the second via insulating layer VIA2 by a deposition process such as a sputtering process. Then, a portion of the pixel electrode layer formed on the upper surface of the second via insulating layer VIA2 may be partially etched to form a pixel electrode PE.

Although FIG. 3 illustrates a single-layer via insulating layer and a single-layer via electrode, the structure of the display device of the present invention is not limited thereto. For example, two, three, or four or more layers of via insulating layers/via electrodes may be included.

Each of the pixel electrodes PE may be provided as an anode of a light emitting element of a corresponding pixel.

According to some embodiments, the pixel electrodes PE may be provided as transmissive electrodes. The pixel electrode PE may comprise a transparent conductive oxide such as indium tin oxide (ITO), indium zinc oxide (IZO), zinc oxide (ZnO), indium tin zinc oxide (ITZO), or the like.

According to some embodiments, the pixel electrode PE may be provided as a transmissive electrode or a reflective electrode. The pixel electrode PE may comprise a metal selected from Ag, Mg, Cu, Al, Pt, Pd, Au, Ni, Nd, Ir, Cr, Li, Ca, Mo, Ti, W, In, Sn, Zn, or an alloy of two or more of these.

The pixel electrode PE may have a monolayer structure or a multilayer structure. For example, the pixel electrode PE may have a three-layer structure of an ITO layer/Ag layer/ITO layer, or an ITO layer/Al layer/ITO layer.

A pixel defining layer PDL may be formed on the second via insulating layer VIA2 and be formed around the pixel electrode PE. For example, the pixel defining layer PDL may cover the periphery of the pixel electrode PE. The upper surface of the pixel electrode PE not covered by the pixel defining layer PDL may be provided as a pixel area or an emission area.

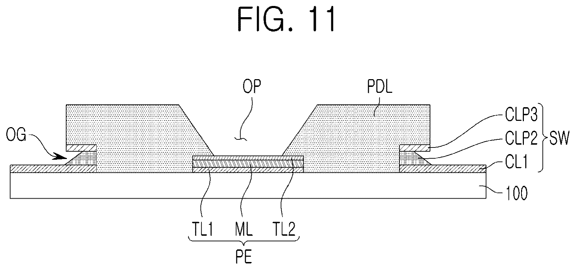

The pixel defining layer PDL may comprise an opening OP (see FIG. 11) that overlaps with or exposes the upper surface of the pixel electrode PE not covered by the pixel defining layer PDL. The inner surface (sidewalls of the opening OP) of the pixel defining layer PDL may be inclined with respect to the third direction (thickness direction) or with respect to the upper surface of the pixel defining layer PDL.

The outer surface of the pixel defining layer PDL may have an inclination angle with respect to the third direction that is less than the inclination angle of the inner surface. According to some embodiments, the outer surface of the pixel defining layer PDL may be parallel or substantially parallel to the third direction. For example, the inclination angle of the outer surface of the pixel defining layer PDL with respect to the third direction may be -10° to 10°, -5° to 5°, or 0°(zero) or approximately 0°.

The pixel defining layer PDL may comprise an inorganic insulating material such as silicon oxide, silicon nitride, silicon oxynitride, or the like. The pixel defining layer PDL may have a monolayer structure comprising any of the above-described inorganic insulating materials, or a multi-layer structure comprising two or more of the above-described inorganic insulating materials.

According to some embodiments of the present invention, a sidewall structure SW may be formed at an outer lower portion of the pixel defining layer PDL. The sidewall structure SW may be inserted into the outer lower portion of the pixel defining layer PDL and may be in contact with the outer lower portion of the pixel defining layer PDL.

The sidewall structure SW may comprise a conductive material. The sidewall structure SW may comprise a first conductive layer CL1, a second conductive pattern CLP2, and a third conductive pattern CLP3 sequentially stacked from an upper surface of the base substrate 100 or a via insulating layer (e.g., a second via insulating layer VIA2). The second conductive pattern CLP2 may have a recessed shape inwardly of the pixel defining layer PDL.

The second conductive pattern CLP2 and the first conductive layer CL1 may comprise different metals. The second conductive pattern CLP2 and the third conductive pattern CLP3 may comprise different metals.

According to some embodiments, the second conductive pattern CLP2 may comprise a metal having an etch selectivity ratio with respect to the first conductive layer CL1 and the third conductive pattern CLP3 for a wet etch process. According to some embodiments, the second conductive pattern CLP2 may comprise aluminum (Al). According to some embodiments, the first conductive layer CL1 and the third conductive pattern CLP3 may comprise titanium (Ti).

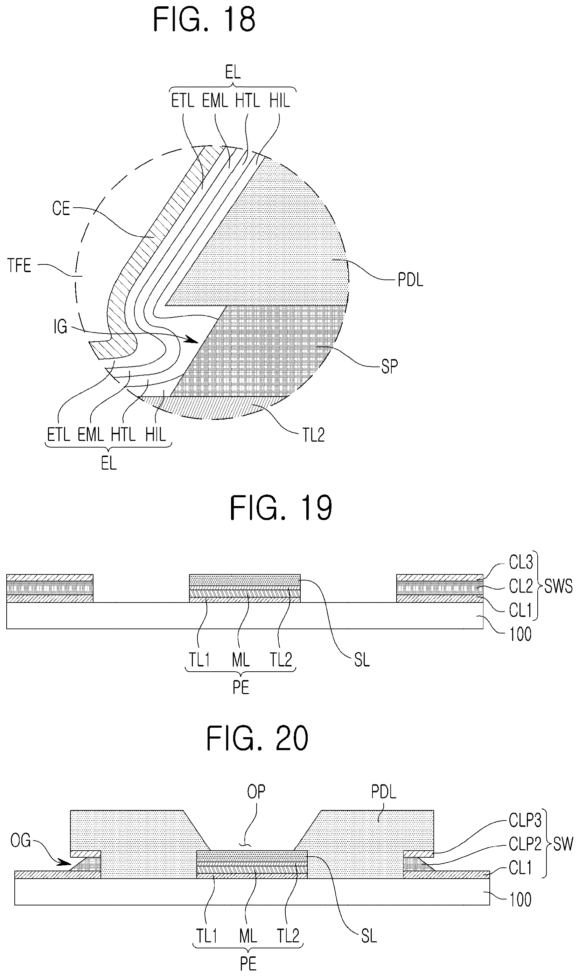

An emission portion EL may be formed on the pixel defining layer PDL and the pixel electrode PE. The emission portion EL may comprise an emission layer EML (see FIG. 18) comprising an organic light emitting material that is independently patterned for each of the red pixel region, green pixel region, and blue pixel region to generate different color light for each pixel.

For example, the emission layer EML may comprise a fluorescent host and/or a host for phosphorescent elements, and may further comprise a fluorescent dopant, a phosphorescent dopant, and/or a thermally active delayed fluorescence (TADF) dopant.

According to some embodiments, the emission portion EL may comprise a plurality of emission layers corresponding to a plurality of different color lights or the same color light, and may comprise a stacks in a tandem structure.

The emission portion EL may further comprise a hole transport layer HTL and an electron transport layer ETL (see FIG. 18). According to some embodiments, the hole transport layer HTL, the emission layer EML, and electron transport layer ETL may be sequentially stacked from the upper surface of the pixel electrode PE.

For example, the hole transport layer HTL may comprise a hole transport material such as m-MTDATA(4,4',4"-[tris(3-methylphenyl)phenylamino] triphenylamine), TDATA(4,4'4"-tris(N,N-diphenylamino)triphenylamine), 2-TNATA(4,4',4"-tris[N(2-naphthyl)-N-phenylamino]-triphenylamine), NPB(N,N'-di(naphthalene-I-yl)-N,N'-diphenyl-benzidine), TPD (N,N'-bis(3-methylphenyl)-N,N'-diphenyl-[1,1'-biphenyl]-4,4'-diamine), TCTA (4,4',4"-tris(N-carbazolyl)triphenylamine), PEDOT/PSS (poly(3,4-ethylenedioxythiophene)/poly(4-styrenesulfonate)), and the like.

For example, the electron transport layer ETL may comprise a electron transport material such as an anthracene-based compound, Alq₃ (tris(8-hydroxyquinolinato)aluminum), TPBi (1,3,5-Tri(1-phenyl-1H-benzo[d]imidazol-2-yl)benzene), BCP(2,9-dimethyl-4,7-diphenyl-1,10-phenanthroline), Bphen(4,7-diphenyl-1,10-phenanthroline), TAZ(3-(4-biphenylyl)-4-phenyl-5-tert-butylphenyl-1,2,4-triazole), NTAZ(4-(naphthalen-1-yl)-3,5-diphenyl-4H-1,2,4-triazole), tBu-PBD(2-(4-biphenylyl)-5-(4-tert-butylphenyl)-1,3,4-oxadiazole), BAlq(bis(2-methyl-8-quinolinolato-N1,O8)-(1,1'-biphenyl-4-olato)aluminum), and the like.

According to some embodiments, a hole injection layer HIL (see FIG. 18) may be further located between the pixel electrode PE and the hole transport layer HTL. An electron injection layer may be further located between the opposing electrode CE and the electron transport layer ETL.

For example, the emission portion EL may be formed by processes such as vacuum deposition, spin coating, inkjet printing, laser printing, casting, laser thermal transfer, and the like.

According to some embodiments, the emission portions EL may be formed continuously along the outer surface, upper surface, and inner surface of the pixel defining layer PDL and the upper surface of the pixel electrode PE not covered by the pixel defining layer PDL. The emission portions EL are blocked by the sidewall structure SW, which may be selectively patterned for each pixel PX accordingly.

An opposing electrode CE may be formed on the emission portion EL. The opposing electrode CE may be provided as an electron injection electrode or a cathode. The opposing electrode CE may comprise a metal, alloy, electrically conductive compound, or the like having a low work function.

For example, the opposing electrode CE may comprise metal layers such as lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), and the like. The opposing electrode CE may comprise a transparent conductive oxide layer, such as ITO, IZO, or the like.

According to some embodiments, the opposing electrode CE may have a multi-layer structure comprising a metal layer (e.g., Mg-Ag layer) and a transparent conductive oxide layer (e.g., IZO layer).

The opposing electrode CE may be provided as a transmissive electrode, a semi-transmissive electrode, or a reflective electrode. The opposing electrode CE may have a monolayer structure or a multi-layer structure.

The opposing electrode CE may entirely cover the emission portion EL and may be discontinuous on the sidewall structure SW. According to some embodiments, the end of the opposing electrode CE may contact the third conductive pattern CLP3 and may not contact the first conductive layer CL1.

The encapsulation layer TFE may be formed on the opposing electrode CE. The encapsulation layer TFE may be located on the pixel defining layer PDL and the light emitting elements to protect the light emitting elements from moisture or oxygen.

The encapsulation layer TFE may comprise an inorganic film comprising silicon nitride (SiNx), silicon oxide (SiOx), indium tin oxide, indium zinc oxide, or any combination thereof.

The encapsulation layer TFE may comprise an organic film comprising polyethylene terephthalate, polyethylene naphthalate, polycarbonate, polyimide, polyethylene sulfonate, polyoxymethylene, polyarylate, hexamethyldisiloxane, acrylic resins (e.g., polymethylmethacrylate, polyacrylic acid, etc.), epoxy resins (e.g., aliphatic glycidyl ether (AGE), etc.), or combinations thereof.

The encapsulation layer TFE may be formed in a monolayer or multi-layer structure. According to some embodiments, the encapsulation layer TFE may have a sequential stacked structure of a first inorganic layer, an organic layer, and a second inorganic layer.

According to some embodiments, the encapsulation layer TFE may be patterned independently for each pixel by the sidewall structure SW. According to some embodiments, the encapsulation layer TFE may contact the sides of the second conductive pattern CLP2 of the sidewall structure SW, and may not contact the first conductive layer CL1.

According to some embodiments, a color control layer overlapping the emission portion EL may be located on the encapsulation layer TFE. The color control layer may comprise a color conversion layer comprising quantum dots and/or a color filter.

According to some embodiments, a sensor layer, such as a touch sensor layer, and/or an optical functional layer, such as a polarizer, an antireflective layer, an antistatic layer, or the like, may be located on the encapsulation layer TFE.

According to the above-described embodiments, the emission portion EL of each pixel may be separated by a sidewall structure SW formed on the outer lower portion of the pixel defining layer PDL. Thus, lateral leakage currents between neighboring pixels may be blocked or reduced.

Furthermore, the emission layer EML may be formed continuously (or substantially continuously) on the pixel electrode PE. An occurrence of a shadow area generated by non-deposition of the light emitting material in the emission area or the pixel area may be prevented or reduced.

At least a portion of the sidewall structure SW is located in the same layer or at the same level as the pixel electrode PE, and the sidewall structure SW may be spaced apart from the pixel electrode PE by the pixel defining layer PDL. The sidewall structure SW may be in contact with ends of the opposing electrodes CE. Thus, the sidewall structure SW may be maintained in electrical connection with the transistor structure TR without the addition of a separated via electrode.

As described above, the sidewall structure SW may comprise a conductive material. Thus, even though the opposing electrodes CE are discontinuous by the sidewall structure SW, they may function as a common electrode for a plurality of pixels through the first conductive layer CL1.

FIGS. 4 to 6 are schematic, partially enlarged cross-sectional views illustrating the stacking of emission portions, opposing electrodes, and encapsulation layers around a sidewall structure, according to some embodiments. For example, FIGS. 4 to 6 are partially enlarged cross-sectional views of the region indicated by the dashed circle in FIG 3.

Referring to FIG. 4, the sidewall structure SW may comprise an outer groove OG. According to some embodiments, the outer groove OG may be defined by an upper surface of the first conductive layer CL1, a side surface of the second conductive pattern CLP2, and a lower surface of the third conductive pattern CLP3.

The emission portion EL may not extend into an interior of the outer groove OG. According to some embodiments, the emission portions EL may extend along the outer surface of the pixel defining layer PDL and may extend over the outer surface of the third conductive pattern CLP3. The emission portion EL may contact the outer surface of the third conductive pattern CLP3 and may not contact the lower surface of the third conductive pattern CLP3. According to some embodiments, the emission portion EL may be in contact with a portion of the outer surface of the third conductive pattern CLP3.

Accordingly, the emission portion EL may be discontinuous by the lower surface of the third conductive pattern CLP3, and does not contact the second conductive pattern CLP2.

The opposing electrode CE may cover a surface of the emission portion EL and may be in contact with the outer surface of the third conductive pattern CLP3. According to some embodiments, the opposing electrode CE may contact the remaining portion of the outer surface of the third conductive pattern CLP that is not covered by the emission portion EL.

Accordingly, the opposing electrode CE may be entirely electrically connected to the sidewall structure SW through the outer surface of the third conductive pattern CLP3.

The encapsulation layer TFE covers the opposing electrodes CE and may contact a sidewall of the second conductive pattern CLP2 in the outer groove OG. According to some embodiments, the encapsulation layer TFE may not contact the upper surface of the first conductive layer CL1.

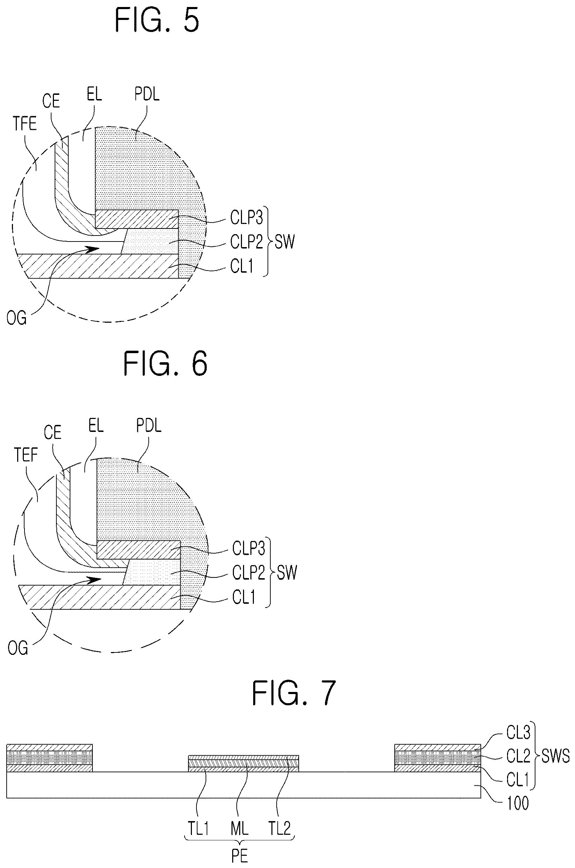

Referring to FIG 5, an end of the opposing electrode CE may partially enter the outer groove OG. The end of the opposing electrode CE may contact the lower surface of the third conductive pattern CLP3. Accordingly, a contact area between the opposing electrode CE and the sidewall structure SW may be increased, thereby reducing the contact resistance.

Referring to FIG. 6, the end of the opposing electrode CE may also be in contact with the sidewall of the second conductive pattern CLP2. In this case, the opposing electrode CE is in contact with the outer surface of the third conductive pattern CLP3, the lower surface of the third conductive pattern CLP3, and the side of the second conductive pattern CLP2 together, which may further reduce the contact resistance.

FIGS. 7 to 11 are schematic cross-sectional views illustrating a method of manufacturing a display device according to some embodiments. For ease of explanation, detailed illustrations of the structures between the pixel electrodes PE and the base substrate 100 are omitted in FIGS. 7 to 11.

Referring to FIG. 7, a pixel circuit comprising a transistor structure TR may be formed on the base substrate 100 as described in FIG. 3 with reference. For example, a sidewall structure stack SWS and a pixel electrode PE electrically connected to the pixel circuit may be formed on a via insulating layer (e.g., a second via insulating layer VIA2).

According to some embodiments, the pixel electrode PE may comprise a first transparent conductive oxide layer TL1, a metal layer ML, and a second transparent conductive oxide layer TL2. The first transparent conductive oxide layer TL1, the metal layer ML, and the second transparent conductive oxide layer TL2 may be formed by a deposition process, such as a sputtering process, sequentially on the via insulating layer, and then the second transparent conductive oxide layer TL2, the metal layer ML, and the first transparent conductive oxide layer TL1 may be partially etched to form the pixel electrode PE.

According to some embodiments, the first transparent conductive oxide layer TL1, the metal layer ML, and the second transparent conductive oxide layer TL2 may be formed to comprise ITO, Ag, and ITO, respectively.

Then, the first conductive layer CL1, the second conductive layer CL2, and the third conductive layer CL3 covering the pixel electrode PE on the via insulating layer may be sequentially formed through a deposition process such as a sputtering process. The portions covering the pixel electrodes PE of the third conductive layer CL3, second conductive layer CL2, and first conductive layer CL1 may be etched to form a sidewall structure stack SWS.

According to some embodiments, the first conductive layer CL1, the second conductive layer CL2, and the third conductive layer CL3 may be formed to comprise Ti, Al, and Ti, respectively.

According to some embodiments, after forming the sidewall structure stack SWS, a pixel electrode PE may be formed.

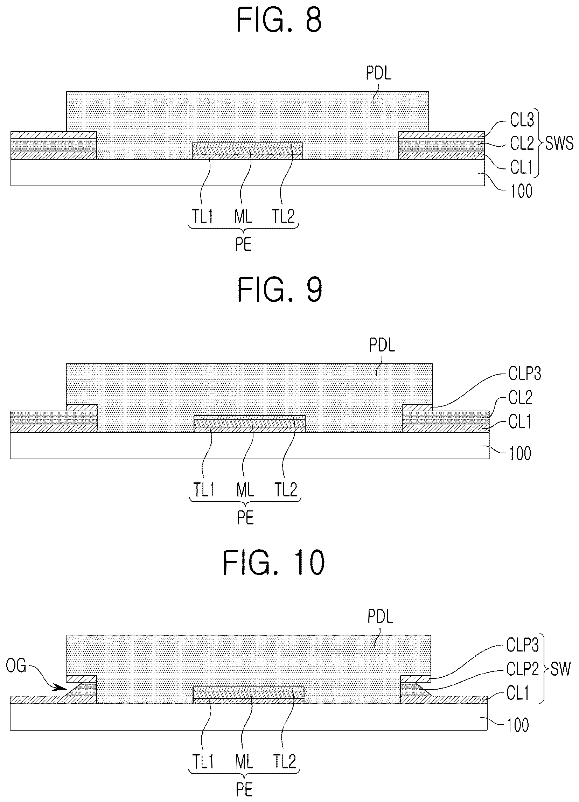

Referring to FIG. 8, a pixel defining layer PDL may be formed that covers the pixel electrode PE and partially covers the sidewall structure stack SWS.

According to some embodiments, an inorganic insulating film comprising an inorganic insulating material such as silicon oxide, silicon nitride, silicon oxynitride, or the like and covering the sidewall structure stack SWS and the pixel electrode PE may be formed by a deposition process, such as a CVD process. Then, an outer portion of the inorganic insulating film may be etched to form a pixel defining layer PDL.

The inner portion of the sidewall structure stack SWS may be covered by the pixel defining layer PDL. An outer portion of the sidewall structure stack SWS may be exposed from the pixel defining layer PDL.

Referring to FIG. 9, a portion of the third conductive layer CL3 exposed from the pixel defining layer PDL may be etched to form a third conductive pattern CLP3. According to some embodiments, the third conductive layer CL3 may be partially removed by performing dry etching with an etch selectivity ratio for the second conductive layer CL2.

The portion of the third conductive layer CL3 covered by the pixel defining layer PDL may remain as the third conductive pattern CLP3.

Referring to FIG. 10, the second conductive layer CL2 may be partially etched to form the second conductive pattern CLP2.

According to some embodiments, the second conductive layer CL2 may be partially etched, for example, by wet etching using an etchant having an etchant selectivity ratio for the second conductive layer CL2 comprising Al. Accordingly, the second conductive layer CL2 may be recessed in the lateral direction of the pixel defining layer PDL to form the second conductive pattern CLP2.

According to some embodiments, the second conductive pattern CLP2 may be recessed to form a sidewall structure SW forming an outer groove OG. As described above, the outer groove OG may be defined by a lower surface of the third conductive pattern CLP3, a side surface of the second conductive pattern CLP2, and an upper surface of the first conductive layer CL1.

As shown in FIG. 10, the side surface of the second conductive pattern CLP2 may be formed as an inclined plane.

Referring to FIG. 11, a portion of the pixel defining layer PDL overlapping the pixel electrode PE may be etched to form an opening OP to expose the pixel electrode PE. The opening OP may partially expose the upper surface of the pixel electrode PE, and the periphery of the pixel electrode PE may be covered by the pixel defining layer PDL.

Then, as described with reference to FIG. 3, an emission portion EL, an opposing electrode CE, and a encapsulation layer TFE may be sequentially formed on the pixel defining layer PDL and the pixel electrode PE.

According to some embodiments, the inclination angle of a sidewall of the opening OP formed in the process illustrated in FIG. 11, with respect to the upper surface of the base substrate 100 or the upper surface of the pixel electrode PE (i.e., the inclination angle of the inner surface of the pixel defining layer PDL), may be smaller than the inclination angle of the outer surface of the pixel defining layer PDL formed in the process illustrated in FIG. 8, with respect to the upper surface of the base substrate 100 or the upper surface of the pixel electrode PE.

Accordingly, the continuity of the emission portions EL on the pixel electrodes PE may be promoted, and the discontinuity in the sidewall structure SW may be effectively induced. Additionally, the opposing electrode CE may also be continuous on the pixel electrode PE and physically discontinuous in the sidewall structure SW to facilitate electrical connection through contact of the sidewall structure SW.

According to some embodiments, as described above, the opposing electrode CE may be formed by a sputtering process as a multi-layer structure comprising a metal layer (e.g., Mg-Ag layer) and a transparent conductive oxide layer (e.g., IZO layer). Accordingly, the step-coverage characteristics may be enhanced and contact with the sidewall structure SW may be facilitated.

According to some embodiments, the inclination angle of the opening OP of the pixel defining layer PDL to the upper surface of the base substrate 100 or the pixel electrode PE may be 30° to 60°, or 40° to 50°. The inclination angle of the outer surface of the pixel defining layer PDL to the upper surface of the base substrate 100 or the pixel electrode PE may be 80° to 100°, or 85° to 95°. According to some embodiments, the outer surface of the pixel defining layer PDL may be perpendicular (or substantially perpendicular) to the upper surface of the base substrate 100 or the pixel electrode PE.

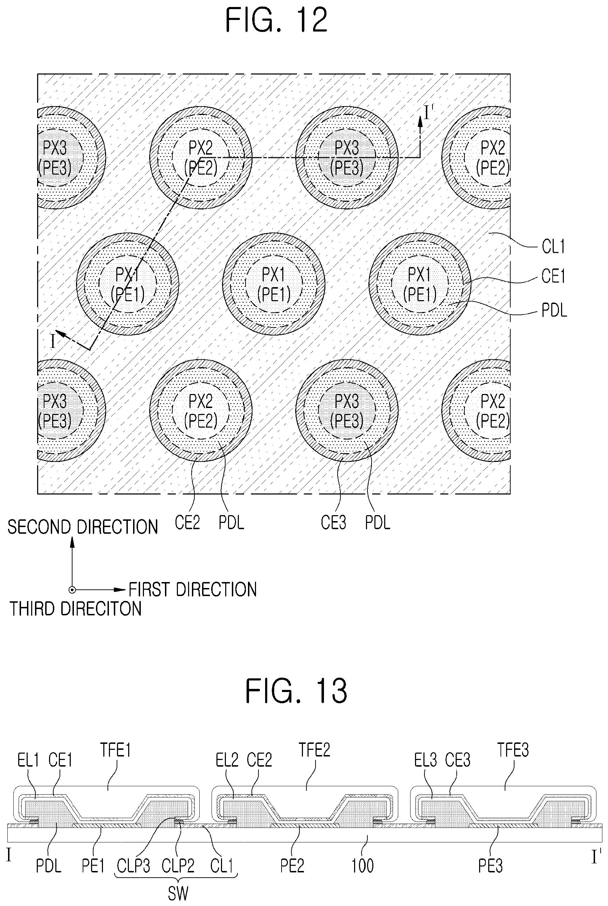

FIGS. 12 and 13 are schematic plan views and cross-sectional views, respectively, illustrating display devices according to embodiments. For example, FIG. 13 is a cross-sectional view cut through in a third direction (thickness direction) along line I-I' in FIG. 12.

For ease of explanation, detailed illustrations of the structures between the pixel electrodes PE1, PE2, PE3 and the base substrate 100 are omitted in FIG. 13. Some detailed descriptions of structures that are the same (or substantially the same) or similar to those described in FIG. 3, which is incorporated by reference, may be omitted.

Referring to FIGS. 12 and 13, the display device may comprise a first pixel PX1, a second pixel PX2, and a third pixel PX3. The first pixel PX1, the second pixel PX2, and the third pixel PX3 may be defined by a first pixel electrode PE1, a second pixel electrode PE2, and a third pixel electrode PE3, respectively, that overlap an opening OP of the pixel defining layer PDL (see FIG. 11).

The first pixel PX1, the second pixel PX2, and the third pixel PX3 may be pixels of different colors. For example, the first pixel PX1, the second pixel PX2, and the third pixel PX3 may correspond to a green pixel, a red pixel, and a blue pixel, respectively.

As shown in FIG. 12, the second pixel PX2 and the third pixel PX3 may be alternately and repeatedly arranged along the first direction to form a first pixel row. The first pixels PX1 may be repeatedly arranged along the first direction to form a second pixel row.

The first pixel row and the second pixel row may be arranged alternately, repeatedly along the second direction. The first pixel PX1, the second pixel PX2, and the third pixel PX3 may be arranged in a zig-zag form along the first direction or along the second direction.

The pixel arrangement shown in FIG. 12 is an example, and may be changed appropriately in consideration of the resolution, luminous efficiency, etc. of the display device.

Each pixel may comprise a pixel electrode PE, a pixel defining layer PDL, a sidewall structure SW, an emission portion EL, an opposing electrode CE, and an encapsulation layer TFE, as described with reference to FIG. 3.

A pixel defining layer PDL may be formed on the first pixel electrode PE1, the second pixel electrode PE2, and the third pixel electrode PE3, respectively, and a sidewall structure SW comprising a first conductive layer CL1, a second conductive pattern CLP2, and a third conductive pattern CLP3 may be formed on an outer lower portion of the pixel defining layer PDL of each pixel.

On the pixel defining layer PDL and the first pixel electrode PE1 of the first pixel PX1, a first emission portion EL1 comprising a first emission layer (e.g., a green emission layer), a first opposing electrode CE1, and a first encapsulation layer TFE1 may be sequentially stacked.

On the pixel defining layer PDL and the second pixel electrode PE2 of the second pixel PX2, a second emission portion EL2 comprising a second emission layer (e.g., a red emission layer), a second opposing electrode CE2 and a second encapsulation layer TFE2 may be sequentially stacked.

On the pixel defining layer PDL and the third pixel electrode PE3 of the third pixel PX3, a third emission portion EL3 comprising a third emission layer (e.g., a blue emission layer), a third opposing electrode CE3, and a third encapsulation layer TFE3 may be sequentially stacked.

Through the sidewall structure SW, the first emission portion EL1, the first opposing electrode CE1, and the first encapsulation layer TFE1 may be selectively patterned in the first pixel PX1. Through the sidewall structure SW, the second emission portion EL2, the second opposing electrode CE2, and the second encapsulation layer TFE2 may be selectively patterned in the second pixel PX2. Through the sidewall structure SW, the third emission portion EL3, the third opposing electrode CE3, and the third encapsulation layer TFE3 may be selectively patterned in the third pixel PX3.

When viewed in the planar direction of FIG. 12, the opposing electrodes CE1, CE2, CE3 and emission portions EL1, EL2, EL3 may entirely cover the pixel defining layer PDL and the pixel electrodes PE1, PE2, PE3 of the corresponding pixel.

According to some embodiments of the present invention, the sidewall structures SW of the first to third pixels PX1, PX2, PX3 may be connected to each other through a first conductive layer CL1. According to some embodiments, the first conductive layer CL1 may be provided as a common connection electrode of the first to third pixels PX1, PX2, PX3, or as a bus-bar electrode.

Accordingly, the first to third opposing electrodes CE1, CE2, CE3 may be electrically connected to each other through the first conductive layer CL1 to provide a common cathode for the first to third pixels PX1, PX2, PX3.

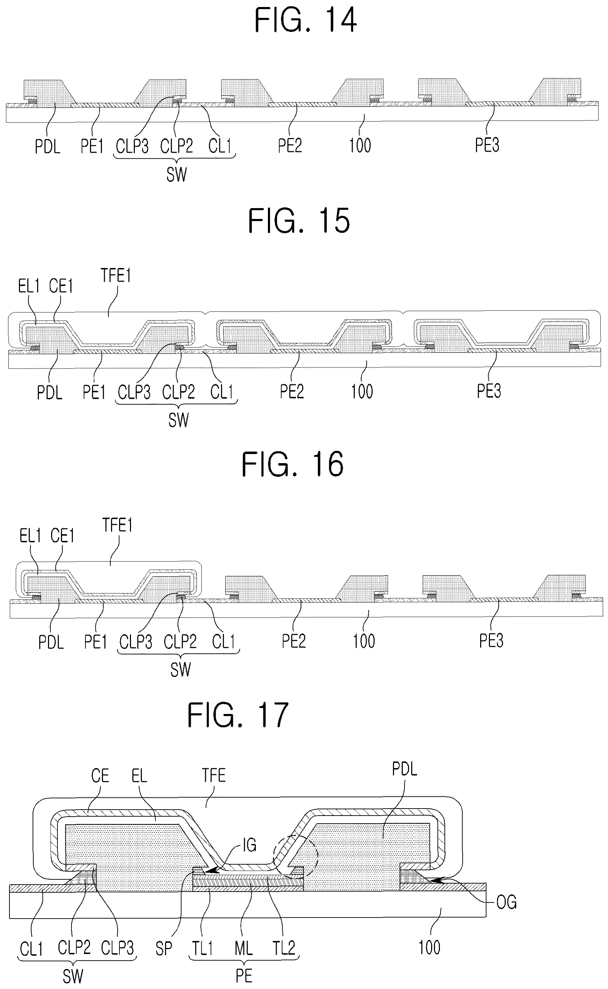

FIGS. 14 to 16 are schematic cross-sectional views illustrating a method of manufacturing a display device according to some embodiments. Some detailed description of the process, which is the same (or substantially the same) or similar to the process described in FIG. 3, and FIGS. 7 to 11 may be omitted.

Referring now to FIG. 14, processes the same (or substantially the same) or similar to the processes described in FIGS. 7 to 11 by reference may be performed.

Accordingly, a first pixel electrode PE1, a second pixel electrode PE2, a third pixel electrode PE3, and a sidewall structure stack SWS (see FIG. 7) may be formed on the base substrate 100.

As described with reference to FIG. 8, a pixel defining layer PDL may be formed to cover the first pixel electrode PE1, the second pixel electrode PE2, and the third pixel electrode PE3, and to partially cover the side wall structure stack SWS.

As described with reference to FIGS. 9 and 10, the third conductive layer CL3 and the second conductive layer CL2 of the sidewall structure stack SWS may be partially etched to form a sidewall structure SW comprising a first conductive layer CL1, a second conductive pattern CLP2, and a third conductive pattern CLP3.

As described with reference to FIG. 11, portions of the pixel defining layer PDL overlapping the first pixel electrode PE1, the second pixel electrode PE2, and the third pixel electrode PE3 may be etched to partially expose the upper surfaces of the first pixel electrode PE1, the second pixel electrode PE2, and the third pixel electrode PE3, respectively.

Referring to FIG. 15, a first emission portion EL1, a first opposing electrode CE1, and a first encapsulation layer TFE1 may be formed on the pixel defining layer PDL and the first to third pixel electrodes PE1, PE2, PE3.

The first emission portion EL1 and the first opposing electrode CE1 may be formed to be discontinuous with the sidewall structure SW of each pixel. The first encapsulation layer TFE1 may contact the sides of the second conductive pattern CLP2 of the sidewall structure SW and fill the space between neighboring first opposing electrodes CE1.

Referring to FIG. 16, the first emission portion EL1, the first opposing electrode CE1, and the first encapsulation layer TFE1 formed in the areas corresponding to the second pixel PX2 and the third pixel PX3 may be removed by a photolithography etch process.

Thus, the first emission portion EL1, the first opposing electrode CE1, and the first encapsulation layer TFE1 may be retained in the area corresponding to the first pixel PX1.

Then, the processes described with reference to FIGS. 15 and 16 may be repeated in the area corresponding to the second pixel PX2, and in the area corresponding to the third pixel PX3.

For example, after sequentially forming the second emission portion EL2, the second opposing electrode CE2, and the second encapsulation layer TFE2, the portions of the second emission portion EL2, the second opposing electrode CE2, and the second encapsulation layer TFE2 formed in the areas corresponding to the first pixel PX1 and the third pixel PX3 may be removed by a photolithography etch process.

Then, after forming the third emission portion EL3, the third opposing electrode CE3, and the third encapsulation layer TFE3 sequentially, the portions of the third emission portion EL3, the third opposing electrode CE3, and the third encapsulation layer TFE3 formed in the areas corresponding to the first pixel PX1 and the second pixel PX2 may be removed by a photolithography etch process.

Accordingly, a stack of emission portions EL, counter electrodes CE, and encapsulation layers TFE selectively patterned for the first to third pixels PX1, PX2, PX3, respectively, may be obtained, as shown in FIG. 13.

FIG 17 is a schematic cross-sectional view illustrating a display device according to some embodiments. Some detailed description of the same (or substantially the same) or similar configurations and structures as described with reference to FIG. 3 may be omitted.

Referring to FIG. 17, an inner groove IG may be formed between an outer portion of a pixel electrode PE and a pixel defining layer PDL. A sacrificial pattern SP may be formed between the pixel defining layer PDL and the outer portion of the pixel electrode PE.

According to some embodiments, the inner groove IG may be defined by an upper surface of the pixel electrode PE (e.g., an upper surface of the second transparent conductive oxide layer TL2), a side of the sacrificial pattern SP, and a lower surface of the pixel defining layer PDL.

The sacrificial pattern SP may comprise a transparent conductive oxide different from the transparent conductive oxide comprised in the second transparent conductive oxide layer TL2. According to some embodiments, the sacrificial pattern SP may comprise an IZO.

FIG. 18 is a schematic partially enlarged cross-sectional view illustrating a shape of separation of emission portions via an inner groove, according to some embodiments. For example, FIG. 18 is a partially enlarged cross-sectional view of the region indicated by the dashed circle in FIG. 17.

Referring to FIG. 18, the inner groove IG formed by the sacrificial pattern SP may cause a break or discontinuity of at least one layer comprised in the emission portion EL.

Referring to FIG. 18, the emission portion EL may comprise a hole injection layer HIL, a hole transport layer HTL, an emission layer EML, and an electron transport layer ETL sequentially stacked on the pixel electrode PE. The hole transport layer HTL and the electron transport layer ETL may comprise a hole transport material and an electron transport material, respectively, as described above. An electron injection layer may be further formed on top of the electron transport layer ETL.

The hole injection layer HIL may comprise the hole transport material comprising a dopant (e.g., a p-type dopant).

According to some embodiments, the hole implantation layer HIL may be interrupted or discontinuous in the inner groove IG. According to some embodiments, the hole injection layer HIL may be discontinuous by the sides of the sacrificial pattern SP.

According to some embodiments, the hole transport layer HTL, emission layer EML, and electron transport layer ETL may extend continuously within the inner groove IG without comprising discontinuous regions (e.g., shadow regions).

According to some embodiments, the hole transport layer HTL may also be discontinuous within the inner groove IG by the sides of the sacrificial pattern SP. The emission layer EML and electron transport layer ETL may extend continuously within the inner groove IG without comprising discontinuous regions (e.g., shadow regions).

According to some embodiments, the recessed distance of the sacrificial pattern SP may be adjusted to induce discontinuities in the hole injection layer HIL, while maintaining continuity in a portion of the emission portion EL other than the hole injection layer HIL. Accordingly, the hole injection layer HIL having a relatively large conductivity may be cut by the dopant, thereby suppressing or reducing the horizontal leakage current between neighboring pixels. Furthermore, the shadow area of the emission layer EML may be avoided and the light emission reliability and efficiency of each pixel may be maintained.

FIGS. 19 to 21 are schematic cross-sectional views illustrating a method of manufacturing a display device according to some embodiments. FIGS 19 to 21 are cross-sectional views illustrating the formation of the inner groove IG and sacrificial pattern SP described with reference to FIG 18. Some detailed description of processes that are the same (or substantially the same) or similar to the processes described in FIGS. 7 to 11, which are incorporated by reference, may be omitted.

Referring to FIG. 19, the same process that is the same (or substantially the same) or similar to the process described with reference to FIG. 7 may be performed except that the formation of a sacrificial layer SL on the second transparent conductive oxide layer TL2 during the formation of the pixel electrode PE is added.

Accordingly, a pixel electrode PE formed on the base substrate 100 or on the via insulating layer may be formed with the sacrificial layer SL on the upper surface.

According to some embodiments, the sacrificial layer SL may be formed by a deposition process, such as a sputtering process, to comprise IZO.

Referring to FIG. 20, the same (or substantially the same) or similar processes may be performed as described in FIGS. 8 to 11 with reference.

Accordingly, a pixel defining layer PDL may be formed that covers the sacrificial layer SL and the pixel electrode PE, and partially covers the sidewall structure stack SWS. The third conductive layer CL3 and the second conductive layer CL2 comprised in the sidewall structure stack SWS may be partially etched to form an outer groove OG, and a sidewall structure SW comprising a first conductive layer CL1, a second conductive pattern CLP2, and a third conductive pattern CLP3 may be formed.

The pixel defining layer PDL may be partially etched to form an opening OP that partially exposes the upper surface of the sacrificial layer SL.

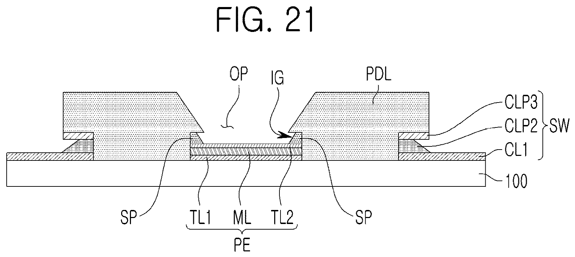

Referring to FIG. 21, the sacrificial layer SL may be partially removed through the opening OP to form a sacrificial pattern SP.

According to some embodiments, the sacrificial pattern SP may be formed by injecting an etchant having an etch selectivity ratio for the IZO through the opening OP. Due to the isotropic nature of wet etching, the portion of the sacrificial layer SL exposed by the opening OP may be partially removed along with the portion of the sacrificial layer SL covered by the pixel defining layer PDL.

Accordingly, the sacrificial pattern SP may have a recessed shape from the sidewall of the opening OP and may form an inner groove IG. The inner groove IG may be defined by an upper surface of the second transparent conductive oxide layer TL2, a side of the sacrificial pattern SP, and a lower surface of the pixel defining layer PDL.

Then, as shown in FIG. 17, an emission portion EL, an opposing electrode CE, and an encapsulation layer TFE may be sequentially formed on the pixel defining layer PDL and the pixel electrode PE. As described with reference to FIG. 18, a discontinuity in the hole injection layer HIL may be induced through the inner groove IG.

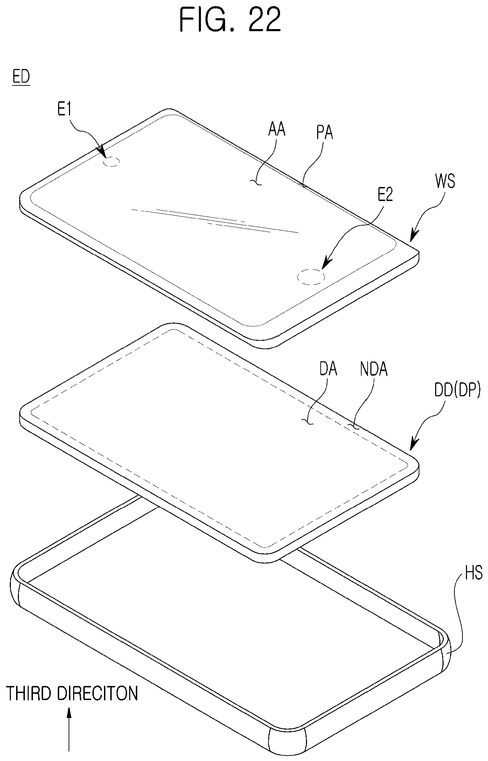

FIG 22 is an exploded perspective view of an electronic device according to some embodiments.

According to some embodiments, the electronic device ED may be implemented in the form of a mobile phone (smartphone), tablet, PC, or the like, comprising the display device described above.

Referring to FIG. 22, the electronic device ED may comprise a window structure WS, a display device DD, and a housing HS. The display device DD may comprise a display panel DP comprising a transistor structure and light-emitting elements as described above. Along the third direction, the housing HS, the display device DD and the window structure WS may be sequentially stacked.

The window structure WS provides an external display surface that is recognized by a user, such as, for example, a viewing surface of an electronic device such as a mobile phone, and may comprise a transparent material film. For example, the window structure WS may comprise glass (e.g., ultra-thin glass (UTG)), a hard-coated film, a plastic film, or the like.

The outer surface of the window structure WS may comprise an active area AA and a periphery area PA. The active area AA may provide a surface on which an image of the display device DD is displayed and on which a user's touch/command is input. The periphery area PA may correspond to a bezel area of the electronic device ED.

As described with reference to FIG. 1, a display device DD or display panel DP may comprise a display area DA and a non-display area NDA. The display area DA of the display panel DP may correspond to or overlap with the active area AA of the window structure WS. The non-display area NDA of the display panel DP may correspond to or overlap with the periphery area PA of the window structure WS. According to some embodiments, the periphery area PA may further comprise a margin area that does not overlap with the non-display area NDA.

According to some embodiments, functional element regions E1, E2 may be comprised within the active area AA of the window structure WS. For example, the first functional element region E1 may be comprised at one end of the active area AA and may be implemented, for example, in the form of a camera hole. The second functional element area E2 may be provided as a fingerprint sensing area.

For example, a sensor structure for touch sensing or fingerprint sensing may be arranged within the display panel DP, or between the window structure WS and the display panel DP.

The housing HS may be provided as a chassis structure or rear housing of the display device DD or the electronic device ED. A cover panel may be located between the housing HS and the display panel DP. The housing HS or the cover panel may comprise a plate (e.g., SUS plate) supporting the display panel DP, printed circuit board 200 (see FIG. 1), and the like. The housing HS or the cover panel may also comprise an elastic body for shock absorption of the display device DD.

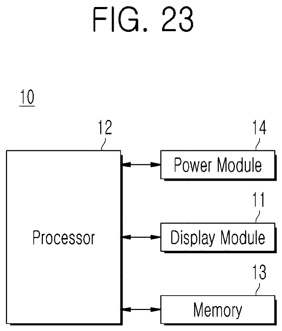

FIG 23 is a block diagram of an electronic device according to some embodiments.

Referring to FIG 23, the electronic device 10 according to some embodiments may comprise a display module 11, a processor 12, a memory 13, and a power module 14.

The processor 12 may comprise a central processing unit (CPU), an application processor (AP), a graphic processing unit (GPU), a communication processor (CP), an image signal processor (ISP), and/or a controller.

The memory 13 may store data information required for operation of the processor 12 or the display module 11. When the processor 12 executes an application stored in the memory 13, image data signals and/or input control signals are delivered to the display module 11, and the display module 11 may process the received signals to output image information via the display screen.

The power module 14 may comprise a power supply module, such as a power adapter or a battery unit, and a power conversion module that converts the power supplied by the power supply module to generate the power required for operation of the electronic device 10.

At least one of the above-described configurations of the electronic device 10 may be comprised within the display device according to the above-described embodiments. Furthermore, some of the individual modules that are functionally comprised within the electronic device 10 may be comprised within the display device and others may be provided separately from the display device. For example, the display module 11 may be comprised in the display device, while the processor 12, memory 13, and power module 14 may be provided in the form of other devices within the electronic device 10 other than the display device.

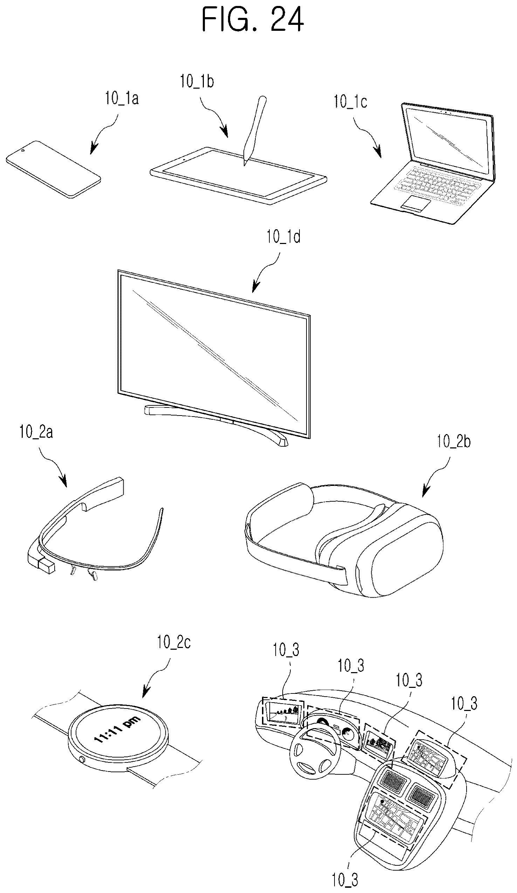

FIG 24 is a schematic diagram of an electronic device according to some embodiments.

Referring to FIG. 24, non-limiting examples of various electronic devices with display devices according to the above-described embodiments comprise smartphones 10_1a, tablet PCs 10_1b, laptops 10_1c, TVs 10_1d, desk monitors 10_1e, and other electronic devices for displaying images; wearable electronic devices comprising display modules such as smart glasses 10_2a, head-mounted displays 10_2b, smart watches 10_2c, and the like; automotive electronic devices comprising display modules such as center information displays (CID), room mirror displays, and the like located on the instrument panel, center fascia, or dashboard of an automobile 10_3, and the like. The electronic device may also comprise virtual reality glasses or augmented reality glasses.

Although aspects of a display device, a method of manufacturing the same and an electronic device comprising the same, according to some embodiments, have been described with reference to the drawings, the illustrated embodiments are examples, and may be modified and changed by a person having ordinary knowledge in the relevant technical field.

## Claims

1. A display device (DD) comprising:
a base substrate (100);
a transistor structure (TR) on the base substrate (100);
a pixel electrode (PE) electrically connected to the transistor structure (TR) on the base substrate (100);
a pixel defining layer (PDL) partially covering the pixel electrode (PE), and having an opening (OP) overlapped the pixel electrode (PE);
a sidewall structure (SW) at an outer lower portion of the pixel defining layer (PDL) and comprising an outer groove (OG);
an emission portion (EL) on the pixel defining layer (PDL) and the pixel electrode (PE); and
an opposing electrode (CE) on the emission portion (EL) and contacting the sidewall structure (SW).

2. The display device (DD) of claim 1, wherein the sidewall structure (SW) comprises a first conductive layer (CL1), a second conductive pattern (CLP2), and a third conductive pattern (CLP3) sequentially stacked on the base substrate (100), and
wherein the outer groove (OG) is defined by an upper surface of the first conductive layer (CL1), a side surface of the second conductive pattern (CLP2), and a lower surface of the third conductive pattern (CLP3).

3. The display device (DD) of claim 2, wherein the opposing electrode (CE) contacts a side surface of the third conductive pattern (CLP3).

4. The display device (DD) of claim 2 to 4, wherein the emission portion (EL) covers an outer side surface of the pixel defining layer (PDL) and does not contact the second conductive pattern (CLP2) of the sidewall structure (SW), and
wherein the emission portion (EL) does not contact the lower surface of the third conductive pattern (CLP3).

5. The display device (DD) of at least one of claims 2 to 4, wherein the opposing electrode (CE) does not contact the first conductive layer (CL1).

6. The display device (DD) of at least one of claims 2 to 5, wherein at least one of the first conductive layer (CL1), the second conductive pattern (CLP2), or the third conductive pattern (CLP3) is in a same layer or at a same level as the pixel electrode (PE).

7. The display device (DD) of at least one of claims 2 to 6, wherein the second conductive pattern (CLP2) comprises a metal different from that of each of the first conductive layer (CL1) and the third conductive pattern (CLP3), preferably wherein the first conductive layer (CL1) and the third conductive pattern (CLP3) comprise titanium and the second conductive pattern (CLP2) comprises aluminum.

8. The display device (DD) of at least one of claims 2 to 7, comprising a plurality of pixels (PX11-PXnm),
wherein the first conductive layer (CL1) of the sidewall structure (SW) is a common connection electrode formed across neighboring pixels (PX11-PXnm) of the plurality of pixels (PX11-PXnm).
wherein the plurality of pixels (PX11-PXnm) comprise a first pixel (PX1), a second pixel (PX2), and a third pixel (PX3),
wherein the pixel electrode (PE) comprises a first pixel electrode (PE1), a second pixel electrode (PE2), and a third pixel electrode (PE3) corresponding to the first pixel (PX1), the second pixel (PX2), and the third pixel (PX3), respectively,
wherein the opposing electrode (CE) comprises a first opposing electrode (CE1), a second opposing electrode (CE2), and a third opposing electrode (CE3) on the first pixel electrode (PE1), the second pixel electrode (PE2), and the third pixel electrode (PE3), respectively, and
wherein the first opposing electrode (CE1), the second opposing electrode (CE2), and the third opposing electrode (CE3) are electrically connected to each other through the first conductive layer (CL1) of the sidewall structure (SW).

9. The display device (DD) of at least one of claims 1 to 8, wherein the emission portion (EL) extends continuously in the opening (OP).

10. The display device (DD) of at least one of claims 1 to 9, wherein an inner groove (IG) is between an outer portion of an upper surface of the pixel electrode (PE) and the pixel defining layer (PDL),
wherein the emission portion (EL) comprises a hole injection layer (HIL), a hole transport layer (HTL), an emission layer (EML), and an electron transport layer (ETL) sequentially stacked on the pixel electrode (PE), and
wherein the hole injection layer (HIL) is discontinuous by the inner groove (IG).

11. The display device (DD) of claim 10, further comprising a sacrificial pattern (SP) formed in the inner groove (IG).

12. A method of manufacturing a display device (DD), the method comprising:
forming a pixel electrode (PE) and a sidewall structure stack (SWS) on a base substrate (100);
forming a pixel defining layer (PDL) covering the pixel electrode (PE) and partially covering the sidewall structure stack (SWS) on the base substrate (100);
forming a sidewall structure (SW) by partially etching the sidewall structure stack (SWS) exposed from the pixel defining layer (PDL);
forming an emission portion (EL) on the pixel defining layer (PDL) and the pixel electrode (PE); and
forming an opposing electrode (CE) contacting the sidewall structure (SW) on the emission portion (EL).

13. The method of manufacturing the display device (DD) of claim 12, wherein the sidewall structure stack (SWS) comprises a first conductive layer (CL1), a second conductive layer (CL2), and a third conductive layer (CL3) sequentially formed from the base substrate (100),
wherein the forming of the sidewall structure (SW) comprises:
forming a third conductive pattern by removing a portion of the third conductive layer (CL1) exposed from the pixel defining layer (PDL) to form a second conductive pattern through dry etching; and
forming an outer groove (OG) by selectively partially removing the second conductive layer (CL2) through wet etching.

14. The method of manufacturing the display device (DD) of claim 13, wherein the emission portion (EL) and the opposing electrode (CE) are formed to be discontinuous by the outer groove (OG).

15. An electronic device (ED), which is especially one of virtual reality or augmented reality glasses, a smartphone (10_1a), a tablet PC (10_1b), a laptop (10_1c), a television (10_1d), a desk monitor (10_1d), smart glasses (10_2a), a head-mounted display (10_2b), a smart watch (10_2c), or an in-vehicle display, the electronic device (ED) comprising:
a display device (DD) according to at least one of claims 1 to 11;
a memory (13); and
a processor (12) configured to control an operation of the display device (DD) by executing a data comprised in the memory (13).
